Europäisches Patentamt

European Patent Office

Office européen des brevets

(11) Publication number: **0 203 623 B1**

# EUROPEAN PATENT SPECIFICATION

(45) Date of publication of patent specification: **17.06.92**  (51) Int. Cl.⁵: **B23K 1/08**, H05K 3/34

(21) Application number: **86200329.0**

(22) Date of filing: **03.03.86**

(54) **Wavesoldering device, particularly for printed circuits.**

(30) Priority: **06.03.85 IT 1978585**

(43) Date of publication of application:
**03.12.86 Bulletin 86/49**

(45) Publication of the grant of the patent:
**17.06.92 Bulletin 92/25**

(84) Designated Contracting States:
**CH DE FR GB LI NL**

(56) References cited:
**EP-A- 0 159 425
DE-A- 3 205 276
FR-A- 2 487 857**

**PATENT ABSTRACTS OF JAPAN, vol. 8, no.
207 (M-327)[1644], 21st September 1984; & JP
- A - 59 94570 (MISUZU SEIKI K.K.) 31-05-1984**

(73) Proprietor: **ITALTEL SOCIETA ITALIANA
TELECOMUNICAZIONI s.p.a.
P.le Zavattari, 12
I-20149 Milano(IT)**

(72) Inventor: **Scorta, Roberto
Via Biraghi, 18
Milan(IT)**

(74) Representative: **Giustini, Delio
c/o Italtel Società Italiana Telecomunicazioni
s.p.a. P.O. Box 10
I-20019 Settimo Milanese (MI)(IT)**

Rank Xerox (UK) Business Services

## Description

It is a well known fact that with the evolution of electronics the dimensions of the separate elements tend to become more and more reduced. Printed circuits are also subject to this tendency, and hence there is an increase in the number of components mounted on each unit of surface of the printed circuit. At the same time, there is also a tendency to mount the components on both sides of the printed circuit, and no longer on just one side.

One of the biggest problems in this compact mounting is the soldering of the components onto the printed circuit. It is a known fact that, for this purpose, nowadays the wavesoldering techique represents the best means to obtain a safe soldering with high productivity and a high degree of automation.

At present a wavesoldering device comprises at least the following parts:

- fluxing unit
- drying unit
- preheating unit
- wavesoldering well
- transporter

Both the transporter, the function of which is obviously to transport the printed circuits over the device and particularly over the wavesoldering well, and the fluxing, drying and preheating units, have structures that are well known to an expert in this field and therefore will not be described in detail now, especially considering that the invention does not relate to these parts so much, but more precisely to the wavesoldering well.

Fundamentally, the wavesoldering well consists of a tank containing the solder, which is maintained in a fluid state, at a constant temperature, by means of heating resistances that are perfectly controlled thermostatically. The tank also comprises a conveyance duct ending in a slot-shaped nozzle that protrudes slightly above the level of the solder bath. A pump immerged in this bath creates a flow of solder from the tank towards the said duct, such that the solder comes out of the slot-shaped nozzle to fall back into the bath forming a wave, that is lengthened out in the same direction as the length of the nozzle.

There are various types of wavesoldering wells on sale, which are capable of forming different types of waves, and a more detailed description of this known technique may be found in relevant pubblications, such as for example, "ASSEMBLAGGIO ELETTRONICO" by Giovanni LEONIDDA, 1978 edition, Editoriale Delfino. A common characteristic of all these different types of wells is that the length of the slot of the slot-shaped nozzle - which as has already been stated, determines the main dimension of the solder wave - is pointed perpendicularly to the main axis of the soldering machine, in other words, in the feed direction of the printed circuits along the machine.

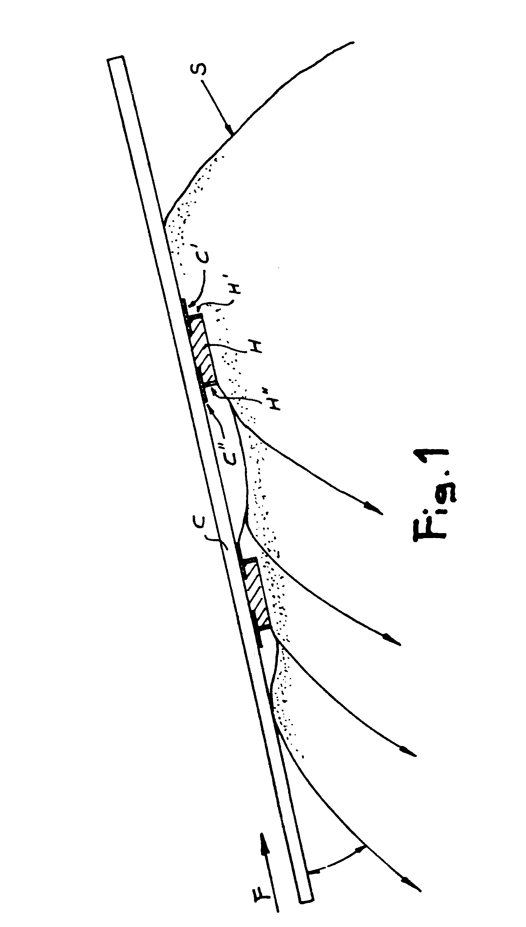

The printed circuits are fed along the machine with their surfaces laying horizontally, or in other words, parallel to the level of the solder bath, or more precisely, slightly slanted in the manner illustrated in fig. 1, and at such a height that their lower face comes into contact with the crest of the wave, which thus solders the metallic parts.

This technique has always proved to be perfectly effective as long as the soldering to be done was on the metallic parts of the printed circuit's lower face, of filiform terminals protruding from the said metallic parts. However, with the soldering of components - for example the so-called chips - on the said lower face, and particularly with the soldering of very dense components, serious difficulties have been met. To be precise, it was found that the said components were soldered correctly on their front face side - seen in relation to the feed direction of the circuit - whilst on their back face, soldering was either incomplete or completely inexistent. This well known phenomenon - currently referred to as "dry soldering", to indicate the fact that some metallic parts of the printed circuit are not bathed by the solder - is illustrated better by referring to the diagram in fig. 1. This fig. shows the diagram of a printed circuit C, which is being fed, slightly slanted (in the sense that its front edge is higher than the back one, in respect to the level of the bath), in direction F, and the lower face of which is lapped by a soldering wave S; it can be seen from this drawing that, whilst the front face H' of each component H and the metallic part C' of the printed circuit right next on it, are completely bathed by the solder, the wave S does not reach the back face H'' and the metallic part C'' next to it. This is mainly due to the feeding movement of the printed circuit, which ends dip creating a back area that cannot be reached by the solder, on the one hand because of the solder's surface tension, and on the other due to the fact that the accumulation of gases developed by the flux is highly favoured in this area.

Fig. 1 illustrates a printed circuit which only has two components applicated onto its lower face, which are spaced out quite alot from one another; in case of more components, and which are perhaps denser as well, as dictated by modern electronics, the "dry soldering" phenomenon is even more noticeable and damaging.

In order to avoid this phenomenon, several different artifices have already been tried, for example, as is partially illustrated in fig. 1:

- by slanting the printed circuit, in other words with its back part lower than its front, so that contact with the wave's crest is more persistent;

- by provoking the formation of a double wave and hence double contact between the solder and the printed circuit, or
- by immerging the printed circuit directly into the solder bath, or even
- by forming a proper jet of solder directed against the lower face of the printed circuit.

However, generally speaking it has not been possible to completely eliminate the aforementioned dry soldering phenomenon, whilst on the other hand, the printed circuits have been subjected - and especially the single components - to a longer period of heating, which is notoriously damaging to the components themselves.

Another technique, even more recent, consists in generating dry azote bubbles and making them bubble inside the solder and towards the contact area between the printed circuit and the solder. Due to the kinetic energy accumulated during their rise towards the surface of the bath and their different specific weight, these bubbles disperse the fluxing gases created during the soldering phase by moving them, and therefore facilitate bathing of the component's back face. However, as can easily be understood, this technique is rather complex and relatively expensive; furthermore, its effectiveness is not always uniform, as the action of the azote bubbles that move the gasseous flux is purely casual, or at least cannot be repeated in a sufficiently constant manner.

Further improvements to the above soldering devices grounded on an lenghthened soldering drive are known, for example, from JP-A-5994570, EP-A-0159425 (Article 54.3 of EPC) and DE-A-3.205.276.

JP-A-5994570 (Misuzu) shows a wave soldering machine where the main direction of the soldering wave is oblique with respect to the feed direction of the printed circuit. As the printed circuits are inclined when they get in contact with the soldering wave, the distance among the single points of the printed circuit and the oblique wave has not a steady length (the above distance is smaller for the first "wet" printed circuit edge, greater for the latest "wet" printed circuit edge) and no effective and homogeneus soldering on the whole printed circuit surface can be reached.

The use of art oblique soldering wave makes easier the elimination of the gas bubbles which cause the "dry soldering" phenomenon, but other means such as, for example, an alternative movement are required for a better use on a soldering machine.

EP-A-0159.425 describes a wave soldering machine where one of the soldering units provides a soldering wave with a linearly reciprocating movement, perpendicular to the printed circuit feeding movement. The linearly reciprocating movement of the soldering wave allows the removal of the gas bubbles, if any, on the front and rear sides of the chips applied to the printed circuit, but not the ones on the other sides of the chips: a soldering wave alternatively travelling perpendicularly to the printed circuit feeding direction is surely an improvement of a know wave soldering machine, but it does not resolve the "dry soldering" problem.

DE-A-3.205.276 describes a soldering device comprising a jet of molten solder subject to an alternative movement, perpendicular to the printed circuits feeding direction, in order to act downwards of the printed circuit.

The use of a jet of solder is known in the art and has been cited at page 4, lines 23-24 of the present application; the element added by the German Patent is the alternative movement of the jet in order to create a pseudo-soldering wave like that one used, for example, in the soldering device described by EP-A-0159.425.

The invention as claimed avoids the inconveniences caused by the soldering methods descrived by the above references considered one by one: in fact, through the combination of the above methods, i.e. by using an alternative oblique soldering wave, we have completely avoided the so-called dry soldering phenomenon. This result is obtained by a process and a device as defined in claims 1 and 3.

Further characteristics and advantages will be made more evident by the description given below of a preferred embodiment which is illustrated in the enclosed drawings in which:

Fig. 1 shows a diagram of the known technique, in accordance with the description given above.

Figs. 2 and 3 schematically illustrate the plan and cross section of a wavesoldering well according to the present invention.

Fig. 4 illustrates in a plan and a corresponding graph, the impact section in a wavesoldering well of the known type.

And fig. 5 is a similar view to fig. 4, for a wavesoldering well made according to the present invention.

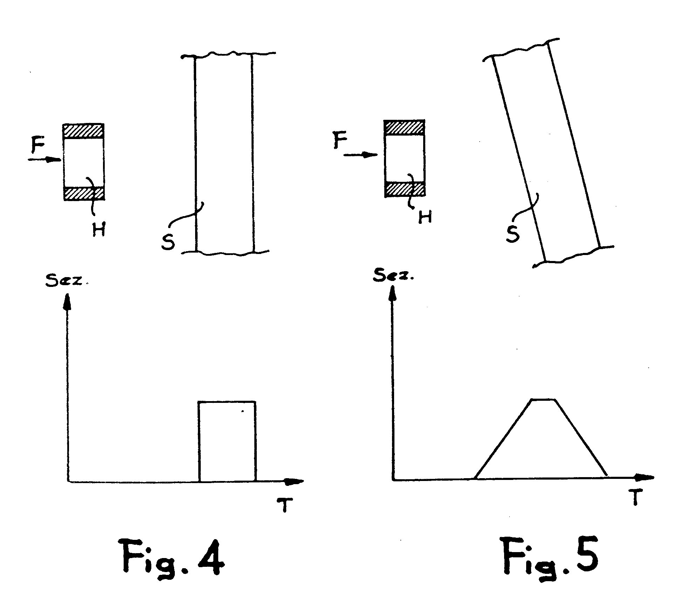

As has already been described, fig. 1 represents what happens when wavesoldering is carried out according to the known technique, on the lower face of a printed circuit C, onto which components H, f or example chips, are applicated. Figure 4 illustrates this situation even more clearly by showing the plan of the component H which is being fed in the direction indicated by the letter F: when the said component H meets the soldering wave S, the impact section - as the graph in the said fig. shows, in which the ordinates represent the impact section SEZ and the abscissae represent the time T - instantly passes from a nil value to a maximum value. The opposite happens in the instant that the component leaves the wave, so that the impact section instantly passes from a maximum value to a nil value: it is in relation to this that the dry soldering phenomenon described at the beginning of the present description occurs.

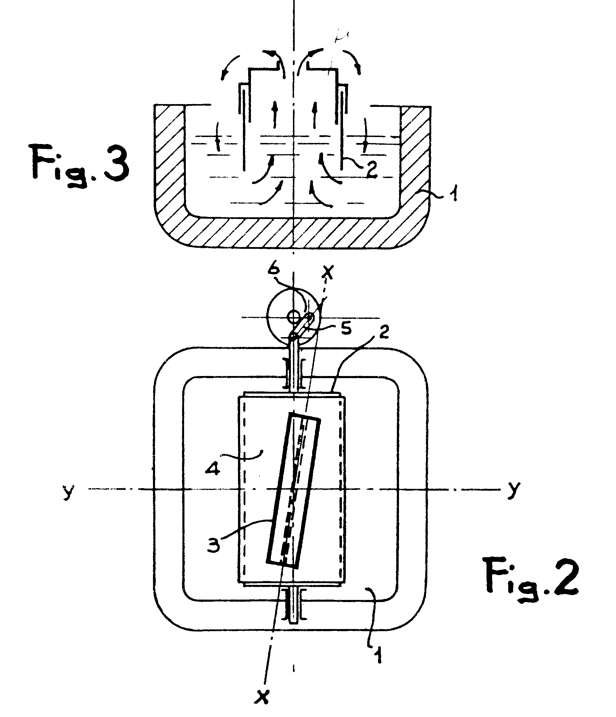

As figs. 2 and 3 illustrate, the device made according to the present invention comprises a well 1 containing solder, maintained in a fluid state and at a controlled temperature by means of heating resistances (not shown, in as much as they are of a known type).

Inside the well 1 there is a duct 2 in which the solder flows in a known manner, from the bottom upwards, to form a wave at the top which falls back into the well 1. According to the invention, the slot-shaped nozzle 3 which is to form the wave is made with its main dimension X-X pointed obliquely in relation to the feed direction Y-Y of the printed circuits. As the front faces, that are being fed forward, of the components fixed onto the printed circuit are normally pointed perpendicularly to the feed direction Y-Y, the said main dimension X-X of the slot-shaped nozzle is thus also obliquely placed in relation to the said front faces of the components.

As fig. 5 illustrates, this arrangement makes the impact section of the component H, which is being fed forward, with the soldering wave, increase in a progressive manner, and diminish in an equally progressive manner. Therefore the component faces the wave in a gradual manner, thus giving it the possibility to cover it as much as possible; furthermore, the fluxing gases have time to escape progressively from the sides, without getting trapped behind the components and so prevent correct soldering.

Furthermore, again according to the invention, the slot-shaped nozzle 3 is made out of one piece 4, which covers the top of the duct 2 like a cap. The piece 4 is mounted to slide sideways, in other words perpendicularly to the direction Y-Y and is associated to a connecting rod 5 and handle 6 mechanism designed to give it an alternative movement, and to be precise that is perpendicular to the direction Y-Y. With modest construction variations it would be possible to also cause an alternative movement in the direction of the axis X-X of the nozzle slot, or even an orbital movement.

This latter arrangement in its turn produces two more favourable effects:

- in fact it creates a state of permanent instability in the wave's mass, and
- the forces going against the component's feed movement - besides being reduced to a minimum, due to what has just been described above - vary continuously, so that infiltration of the solder between the components is facilitated, and gases are forced out.

The oblique soldering wave could be doubled, and each of the two waves could be inclined differently in relation to the feed direction of the printed circuits, or the two waves could even have opposite inclinations to one another. In these cases the vibrations of the two waves could be synchronized or in some way differentiated. It must, on the other hand, be pointed out that the same result could be obtained by directing the vibrating soldering wave in such a manner that its largest dimension is perpendicular to the feed direction of the printed circuits and then feeding the printed circuits obliquely in relation to the said feed direction. The fundamental thing, in as far as the present invention is concerned, is that the front faces of the components mounted on the printed circuits are pointed obliquely in relation to the largest dimension of the soldering wave subject to an orbital or to a linearly reciprocating movement.

## Claims

1. Process for wavesoldering printed circuits (C), particularly circuits carrying discreet components (H), such as chips for example, on the surface on which the soldering is to be carried out, of the type in which the printed circuits (C) have a relative movement in relation to a soldering tank (1), in which a duct (2) with a slot-shaped nozzle (3) forms wave (S) of molten solder lengthened out along its main dimension (Y-Y) and pointed oblique in relation to the feed direction of said components (H) to be soldered, characterized in at said slot-shaped nozzle (3) is subjected to an orbital or a linearly reciprocating movement along its main dimension.

2. Process as claimed in claim 1, characterized in that the main dimension of the soldering wave (S) is perpendicular to the feed direction of the printed circuits (C) and the general alignment of the front faces of the components (H) applicated onto the printed circuits (C) is oblique in relation to said feed direction.

3. Device for soldering printed circuits (C), which have discreet components (H) applicated onto their surface to be soldered, device comprising means to transport the printed circuits (C) in a feed direction (Y-Y) and a wavesoldering tank (1) provided with a slot-shape nozzle (3) to form a wave, said slot-shaped nozzle (3) being pointed obliquely in relation to the feed direction (Y-Y) of said transport means, characterized in that said slot-shaped nozzle (3) is connected to means designed to give it an orbital or a linearly reciprocating movement along its main dimension.

4. Device as claimed in claim 3, characterized in that said oblique slot-shaped nozzle (3) is formed in the lid of the wavesoldering tank (1), and is mobile in respect to the tank (1) and to which the said means (5, 6) to give it an orbital or an alternative movement are connected.

5. Device as claimed in claim 4, characterized in that said lid of the wavesoldering tank (1), with the oblique slot-shaped nozzle (3) mounted in it, slides perpendicularly to said feed direction.

**Revendications**

1. Procédé pour le soudage à ondes de circuits imprimés (C), surtout circuits portant des composants discrets (H), tels que puces par exemple, sur la surface desquels la soudure doit être réalisée, du type où les circuits imprimés (C) ont un mouvement relatif par rapport à un bac de soudage (1), où une conduite (2) avec une buse en forme de fente (3) forme une onde (S) d'alliage de soudure coulé allongée le long de sa dimension principale (Y-Y) et dirigée de manière oblique par rapport à la direction d'alimentation des susdits composants (H) à être soudés, caractérisé par le fait que ladite buse en forme de fente (3) est sujette à un mouvement orbital ou alternatif linéaire le long de sa dimension principale.

2. Procédé comme revendiqué dans la revendication 1, caractérisé par le fait que la dimension principale de l'onde de soudage (S) est perpendiculaire à la direction d'alimentation des circuits imprimés (C) et que l'alignement général des faces frontales des composants (H) appliqués sur les circuits imprimés (C) est oblique par rapport à ladite direction d'alimentation.

3. Dispositif pour le soudage de circuits imprimés (C), qui ont des composants discrets (H) appliqués sur leur surface à être soudés, dispositif comprenant des moyens pour transporter les circuits imprimés (C) vers une direction d'alimentation (Y-Y) et un bac pour soudage à ondes (1) doté d'une buse en forme de fente (3) pour former une onde, ladite buse en forme de fente (3) étant dirigée de manière oblique par rapport à la direction d'alimentation (Y-Y) des susdits moyens de transport, caractérisé par le fait que ladite buse en forme de fente (3) est reliée aux moyens projetés pour lui donner un mouvement orbital ou alternatif linéaire le long de sa dimension principale.

4. Dispositif comme revendiqué dans la revendication 3, caractérisé par le fait que ladite buse oblique en forme de fente (3) est formée dans la porte du bac de soudage à ondes (1), et est mobile par rapport au bac (1) et à laquelle sont reliés lesdits moyens (5, 6) qui lui donnent un mouvement orbital ou alternatif linéaire.

5. Dispositif comme revendiqué dans la revendication 4, caractérisé par le fait que ladite porte du bac de soudage à ondes (1), avec la buse oblique en forme de fente (3) montée dans celle-ci, glisse perpendiculairement à la susdite direction d'alimentation.

**Patentansprüche**

1. Verfahren fuer Wellenloetung von gedruckten Schaltungen (C), insbesondere von Schaltungen mit aus einzelnen Teilen bestehenden Komponenten (H) wie Chips zum Beispiel, an deren Oberflaeche die Loetung ausgefuehrte werden soll, und zwar des Typs, bei dem die gedruckten Schaltungen (C) eine relative Bewegung in Bezug auf einen Schweisstank (1) ausfuehren, in dem eine Leitung (2) mit einer schlitzfoermigen Duese (3) eine Welle (S) von geschmolzenem Loetmetall bildet, das sich laengs ihrer Hauptabmessungen (Y-Y) erstreckt und und schraeg in Bezug auf die Speiserichtung besagter, zu loetender Komponenten (H) deutet, dadurch gekennzeichnet, dass die besagte schlitzfoermige Duese (3) einer Orbital- oder sich linear hin- und herbewegenden Bewegung laengs ihrer Hauptabmessungen unterworfen wird.

2. Verfahren wie unter Anspruch 1 aufgefuehrt, gekennzeichnet dadurch, dass die Hauptabmessungen der Loetwelle (S) sich senkrecht zu der zufuhrrichtung der gedruckten Schaltungen (C) verhaelt und dass die allgemeine Ausrichtung der Vorderseiten der auf den gedruckten Schaltungen (C) angebrachten Komponenten (H) im Verhaeltnis zu besagter Zufuhrrichtung schraeg verlaeuft.

3. Vorrichtung fuer die Loetung von gedruckten Schaltungen (C), an deren zu loetender Oberflaeche getrennte Komponenten (H) angebracht sind; diese Vorrichtung umfasst Mittel Euer den Transport der gedruckten Schaltungen (C) in eine Speiserichtung (Y-Y) sowie einen Wellenloettank (1), der mit einer schlitzfoermigen, eine Welle bildenden Duese (3) versehen ist, wobei die besagte schlitzfoermige Duese (3) schraeg in Bezug auf die Speiserichtung (Y-Y) besagter Transportmittel verlaeuft, und gekennzeichnet dadurch, dass die besagte schlitzfoermige Duese (3) mit Mitteln verbunden ist, die so ausgelegt wurden, dass ihr eine orbitale oder linear sich hin- und herbewegende Bewegung verliehen wird.

4. Vorrichtung gemaess Anspruch 3, gekennzeichnet dadurch, dass die besagte schraege schlitzfoermige Duese (3) im Deckel des Wellenloettank (1) gebildet wird und im Verhaeltnis zum Tank (1) beweglich ist und mit der die besagten Mittel (5, 6) verbunden sind, um ihr eine Orbital- oder oder Wechselbewegung zu verleihen.

5. Vorrichtung gemaess Anspruch 4, dadurch gekennzeichnet, dass der besagte Deckel des Wellenloettanks (1) mit der darin montierten schraegen, schlitzfoermigen Duese (3) senkrecht in besagte Speiserichtung gleitet.

Fig.1

EP 0 203 623 B1

Fig.3

Fig.2

Fig. 4

Fig. 5